Europäisches Patentamt

European Patent Office

Office européen des brevets

(19)

(11) Veröffentlichungsnummer : **0 479 787 B1**

(12) # EUROPÄISCHE PATENTSCHRIFT

(45) Veröffentlichungstag der Patentschrift :
**04.10.95 Patentblatt 95/40**

(51) Int. Cl.$^6$ : **H03M 7/30, H03M 7/42**

(21) Anmeldenummer : **90904601.3**

(22) Anmeldetag : **21.03.90**

(86) Internationale Anmeldenummer :
**PCT/DE90/00223**

(87) Internationale Veröffentlichungsnummer :
**WO 91/00652 10.01.91 Gazette 91/02**

(54) **VERFAHREN ZUR CODIERUNG EINER ELEMENTFOLGE UND EINRICHTUNG ZUR DURCHFÜHRUNG DES VERFAHRENS.**

(30) Priorität : **30.06.89 DE 3921646**

(43) Veröffentlichungstag der Anmeldung :
**15.04.92 Patentblatt 92/16**

(45) Bekanntmachung des Hinweises auf die
Patenterteilung :
**04.10.95 Patentblatt 95/40**

(84) Benannte Vertragsstaaten :
**BE DE FR GB IT NL SE**

(56) Entgegenhaltungen :
**Mini-Micro Systems, Band 21, Nr. 2, Februar
1988, (Newton, MA, US), F. BACON et al.:
"How to Quadruple Dial-Up Communications
Efficiency", seiten 77-81**

(73) Patentinhaber : **SIEMENS
AKTIENGESELLSCHAFT
Wittelsbacherplatz 2
D-80333 München (DE)**

(72) Erfinder : **KUTKA, Robert
Hainbuchenstrasse 3
D-8085 Geltendorf (DE)**

EP 0 479 787 B1

Anmerkung : Innerhalb von neun Monaten nach der Bekanntmachung des Hinweises auf die Erteilung
des europäischen Patents kann jedermann beim Europäischen Patentamt gegen das erteilte europäische Patent Einspruch einlegen. Der Einspruch ist schriftlich einzureichen und zu begründen. Er gilt
erst als eingelegt, wenn die Einspruchsgebühr entrichtet worden ist (Art. 99(1) Europäisches Patentübereinkommen).

**Beschreibung**

Die Erfindung betrifft ein Verfahren zur Codierung einer Elementfolge, insbesondere zur Erzeugung des Lempel/Ziv-Codes für eine solche Elementfolge.

Für eine Redundanzreduktion einer Folge beispielsweise von Koeffizienten einer Diskret-Cosinus-Transformation für Bildwerte von Bildpunkten eines Abbildes, insbesondere eines medizinischen Diagnosebildes etwa eines Röntgenbildes, wird häufig nach A.Lempel und J.Ziv ein Code benutzt.

Die Autoren Abraham Lempel und Jakob Ziv beschreiben in der Zeitschrift IEEE Transactions on Information Theory, Vol. IT-23, Mai 1977, unter dem Titel "A Universal Algorithm for Sequential Data Compression" eine Codierung einer Elementfolge. Vereinbarungsgemäß kooperieren dabei die Codierung und die Decodierung. Bei der Codierung wird die zu codierende Elementfolge Element für Element sequentiell verarbeitet. Dabei werden jeweils eines der Elemente oder jeweils mehrere der Elemente als Teilfolge behandelt. Jede der Teilfolgen besteht demnach wenigstens aus einem der Elemente. Jede der Teilfolgen ist durch ein hinzugefügtes Element erweiterbar zu einer weiteren der Teilfolgen. Beim Beginn der Codierung ist vereinbarungsgemäß zu jedem vereinbarten Element eines Elementevorrates, welcher häufig auch Alphabet genannt wird, jeweils eine Teilfolge bekannt bestehend jeweils aus genau einem der Elemente. Häufig werden diese anfangs bekannten Teilfolgen auch die primären Teilfolgen genannt. Als Ergebnis der Codierung wird ein Code erzeugt, welcher aus Codeworten besteht, welche eine Codewortfolge bilden. Dabei entspricht jedes Codewort jeweils einer Teilfolge. Beim Beginn der Codierung und ebenso beim Beginn der Decodierung ist zugeordnet zu jedem Element des Elementevorrates, und damit also zugeordnet zu jeder primären Teilfolge jeweils ein Codewort vereinbart. Diese Codeworte werden häufig auch die primären Codeworte genannt.

Beginnend mit dem ersten Element der zu codierenden Elementfolge wird die zu diesem Element primäre Teilfolge erkannt, und das hierzu zugeordnete Codewort wird als erstes Codewort des Codes in den Code eingetragen. Danach wird das nächstfolgende Element der zu codierenden Elementfolge verarbeitet. Jeweils nach einer erkannten Teilfolge kommt das nächstfolgende Element in zweierlei Hinsicht zur Verarbeitung. Erstens wird die zuletzt erkannte Teilfolge durch dieses Element erweitert zu einer erweiterten neuen erkannten Teilfolge, welcher ein nächstfolgendes Codewort zugeordnet wird. Dieses Codewort ist dabei das nächstfolgende aus einer hierfür vereinbarten Reihenfolge. Und zweitens wird dieses die Teilfolge erweiternde Element für die Suche nach nachfolgenden Teilfolgen für die zu suchenden weiteren Teilfolgen als erstes Element aufgegriffen. Gesucht wird jeweils eine aus möglichst vielen unmittelbar nachfolgenden Elementen bestehende Teilfolge, für welche bereits ein Codewort zugeordnet ist.

F. Bakon gibt in seinem Artikel "How to quadruple dial-up communications efficiency", Mini-Micro Systems, Bd. 21, Nr. 2, Febr. 88, Newton, MA, USA, pp. 77-81, eine allgemeine Darstellung des Lempel-Ziv-Verfahrens zur Codierung zeitlicher Folgen von Elementen eines Alphabets. In diesem Papier von F. Bacon wird ein Codierverfahren beschrieben, das sog. Telcore-Modell, welches als Verbindung des Lempel-Ziv-Verfahrens mit der Huffman-Codierung zu verstehen ist. Dieses Verfahren ist nicht zur Erzeugung des Lempel-Ziv-Codes geeignet und auch sonst nicht mit Lempel-Ziv-Codern kompatibel. Aus der Veröffentlichung von F. Bacon ist ein Beitrag zur Lösung der Aufgabe, welche diesem Patentbegehren zugrundeliegt, nicht zu entnehmen. Es wird insbesondere kein Hinweis auf ein Verfahren zur Codegenerierung unter Vermeidung einer Suche nach Codeworten gegeben.

Bei der Codierung ist dabei jeweils die gesamte Liste der bisher erkannten Teilfolgen zu durchsuchen. Das Codewort, welches der längsten dieser Teilfolgen zugeordnet ist, wird in den Code eingetragen. Danach wird mit dem auf diese Teilfolge nächstfolgenden Element ebenso einerseits diese Teilfolge erweitert und andererseits die Suche nach nachfolgenden Teilfolgen begonnen.

Bei der Decodierung werden zu den Codeworten die zugeordneten Teilfolgen decodiert. Dabei wird ebenso die jeweilige Teilfolge durch das unmittelbar nachfolgende Element jeweils erweitert zu einer erkannten erweiterten Teilfolge. Für diese wird ebenso jeweils ein nächstfolgendes Codewort zugeordnet, welches ebenso gemäß der hierfür vereinbarten Reihenfolge zuordenbar ist.

Mit jeder erweiterten Teilfolge wird damit auch die Liste der bisher erkannten Teilfolgen verlängert. Die jeweils zu durchsuchende Liste wächst daher ständig an. Dadurch verlangsamt sich auch ständig die Codierung.

Die Aufgabe der Erfindung besteht darin, daß ein äußerst schnelles Verfahren zur Codierung einer Elementfolge unter Vermeidung einer Suche angegeben wird, wobei ein Lempel/ Ziv-Code erzeugt werden soll.

Diese Aufgabe wird durch ein Verfahren mit den im Patentanspruch 1 angegebenen Merkmalen gelöst.

Vereinbarungsgemäß wird von primären Teilfolgen bestehend aus jeweils einem Element ausgegangen. Dabei bilden die Elemente den vorgegebenen Elementevorrat. Vereinbarungsgemäß ist die Reihenfolge der Elemente definiert. Zu jedem der Elemente ist auch eine Elementposition vereinbart, welche jeweils gleich ist einer Codewortposition des zugeordneten primären Codewortes in der vereinbarten Codewortreihenfolge, für die Zuordnung von Codeworten. Diese Position wird benutzt für das Auffinden der dem Element zugeordneten Codierungsstelle innerhalb einer Codierungsstufe. An jeder Codierungsstelle ist in jeder der Codierungsstufen einerseits ein Codewort und andererseits ein Codierungsstufenzeiger markierbar. Außerdem ist vorgesehen, daß es erkennbar ist, falls ein Codewort und/oder ein Codierungsstufenzeiger nicht markiert ist. Dabei wird eine einmal vorgenommene Markierung weder abgeändert noch rückgängig gemacht.

Ausgehend von einer primären Codierungsstufe werden soweit erforderlich weitere der Codierungsstufen nach und nach in Form einer baumartigen Codierungsstruktur mittels der Codierungsstufenzeiger gekettet. Diese Codierungsstruktur wird dabei dafür benutzt, die Suche nach erkannten Teilfolgen effizient und schnell durchzuführen. Dabei wird jeweils das erste Element der untersuchten Teilfolge gemäß seiner über die Elementposition ermittelbaren Codierungsstelle in der primären Codierungsstufe überprüft. Dabei verweist ein an dieser Codierungsstelle markierter Codierungsstufenzeiger auf die solcher Art gekettete Codierungsstufe, in welcher das unmittelbar nächstfolgende Element der untersuchten Teilfolge überprüft wird. Gemäß der diesem Element zugeordneten über die Elementposition ermittelbaren Codierungsstelle wird in der Codierungsstufe überprüft, ob ein Codierungsstufenzeiger markiert ist. Durch ein markiertes Codewort ist jeweils erkennbar, ob die bisher untersuchten Elemente eine bereits erkannte Teilfolge bilden. Auf diese Weise ist mit Hilfe der Codierungstuktur für jedes verarbeitete Element das zugeordnete Codewort zur bisher untersuchten Teilfolge vorteilhaft auffindbar.

Der Aufbau der Codestruktur erfolgt dabei schrittweise und jeweils abhängig von der zu codierenden Elementfolge und den darin enthaltenen erkennbaren Teilfolgen. Zu jeder der vereinbarungsgemäß vorgebbaren primären Teilfolgen wird jeweils ein Codewort an der über die Elementposition des Elementes ermittelbaren Codierungsstelle in der primären Codierungsstufe markiert. Nach der Durchführung dieses Initialisierungsvorganges wird das erste Element der zu codierenden Elementfolge bearbeitet. An der diesem Element zugeordneten über die Elementposition ermittelbaren Codierungsstelle wird aus der primären Codierungsstufe das markierte Codewort erhalten einerseits und andererseits wird erkannt, daß zu dieser vorgefundenen primären Teilfolge keine erweiternde Teilfolge bislang vorgefunden wurde. Dies erfolgt beispielsweise dadurch, daß der in der primären Codierungsstufe an der Codierungsstelle markierte Codierungsstufenzeiger gleich Null ist. Das an der Codierungsstelle markierte Codewort der vorgefundenen Teilfolge wird in die Codefolge eingefügt. Beispielsweise wird geprüft, ob einerseits weitere Codeworte verfügbar sind und andererseits, ob weitere Codierungsstufen hinzufügbar sind. Gegebenenfalls wird in der vorgefundenen Codierungsstufe zusätzlich zum die vorgefundene Teilfolge an der Codierungsstelle markierenden Codewort zur Kettung mittels eines Codierungsstufenzeigers eine hinzugefügte Codierungsstufe markiert. In der hinzugefügten Codierungsstufe wird an der Codierungsstelle des unmittelbar nächstfolgenden Elementes die durch dieses Element erweiterte Teilfolge mittels eines weiteren der Codeworte markiert. Mit diesem erweiternden Element wird die Codierung der Elementfolge erneut beginnend mit der primären Codierungsstufe fortgesetzt. Element für Element wird die Elementfolge nach vorhandenen Teilfolgen durchsucht. Die dabei vorgefundenen Teilfolgen bestehen aus jeweils einem primären Element der jeweiligen primären Teilfolge, welche fallweise durch jeweils nächstfolgende Elemente zu jeweils weiteren Teilfolgen erweitert wird. Zu jedem Element einer vorgefundenen Teilfolge existiert dabei jeweils eine vorgefundene Teilfolge bestehend aus den jeweils vorhergehenden Elementen. Zu jedem Element einer vorgefundenen Teilfolge existiert eine für die Überprüfung dieses Elementes vorgesehene Codierungsstufe. In dieser ist an der dem Element zugeordneten Codierungsstelle markiert, einerseits das Codewort der bisherigen Teilfolge, sowie andererseits, ob weitere vorgefundene erweiterte Teilfolgen markiert sind. Für den Fall, daß eine vorgefundene erweiterte Teilfolge markiert ist, markiert der Codierungsstufenzeiger eine weitere Codierungsstufe. Für den Fall, daß keine weitere Codierungsstufe markiert ist, wird für das nächstfolgende Element, wie beschrieben, eine weitere Codierungsstufe hinzugefügt. Anderenfalls wird für das nächstfolgende Element in der hinzugefügten Codierungsstufe an der Codierungsstelle geprüft, ob ein Codewort und damit eine vorgefundene Teilfolge markiert ist. Für den Fall, daß in der hinzugefügten Codierungsstufe an der Codierungsstelle beispielsweise ein Codewort gleich Null markiert ist, wird durch dieses Element die bisherige Teilfolge durch Verzweigung erweitert. In diesem Fall ist die bisherige Teilfolge bereits zuvor zu einer bereits bekannten vorgefundenen Teilfolge erweitert worden durch ein anderes der Elemente, als es jetzt auf die bisherige Teilfolge nachfolgt. Zur bisherigen Teilfolge gibt es demnach verzweigend zwei vorgefundene Erweiterungen zu zwei erweiterten Teilfolgen. Die zuletzt vorgefundene verzweigend erweiterte Teilfolge wird ebenso durch ein zugeordnetes Codewort markiert. Es wird an der Codierungsstelle des erweiternden Elementes zugeordnet zu der erweiterten Teilfolge jeweils ein weiteres der Codeworte markiert. Dabei wird jeweils das Codewort der bisher vorgefundenen Teilfolge in die zu erzeugende Codefolge eingefügt. Auf diese Weise wird die Codefolge aus Codeworten von bereits vorgefundenen Teilfolgen aufgebaut. Jedes eine vorgefundene Teilfolge erweiternde Element wird nachfolgend jeweils an der Codierungsstelle in der primären Codierungsstufe überprüft, und jedes weitere nachfolgende Elemente wird jeweils in der hierfür hinzugefügten und mittels des Codierungsstufenzeigers aufgefundenen Codierungsstufe überprüft. Durch ein markiertes Codewort wird dabei eine bereits vorgefundene Teilfolge erkannt. Auf diese Weise ist für jedes der zu überprüfenden Elemente jeweils direkt die Elementposition in der jeweiligen Codierungsstufe auffindbar, so daß durch ein markiertes Codewort die vorgefundene Teilfolge erkennbar ist, und andererseits durch den Codierungsstufenzeiger eine Erweiterung der Teilfolgen erkennbar ist. Einerseits sind dadurch vorgefundene Teilfolgen auf besonders einfache Weise überprüfbar, und andererseits ist dadurch eine Erweiterung der bestehenden Teilfolgen auf besonders einfache Weise realisierbar. Durch das erfindungsgemäße Codegenerierungsverfahren ist dadurch eine eine äußerst schnelle Codierung der Elementfolge erzielbar.

Eine bevorzugte Ausführungsform des Codegenerierungsverfahrens ist dadurch gekennzeichnet, daß in einem Umsetzungsverfahren die Elementfolge aus einer Primärfolge bestehend aus Primärelementen eines bezüglich des Elementevorrates größeren Primärvorrates erhalten wird, indem wenigstens ein Escapeelement aus den Elementen des Elementevorrates vorgegeben wird, und alle übrigen der Elemente des Elementevorrates zugeordnet werden jeweils einem der Primärelemente des Primärvorrates, und alle übrigen der Primärelemente des Primärvorrates werden zugeordnet jeweils einer Escapesequenz, welche jeweils gebildet wird aus wenigstens einem der Escapeelemente und wenigstens einem der Elemente des Elementevorrates. Die zu codierende Elementfolge wird dabei durch Umsetzung aus einer Primärfolge erhalten. Dabei wird der größere Primärvorrat der Primärelemente verkleinert zum Elementevorrat der Elementfolge. Durch diese Umsetzung wird die Zahl der Codierungsstellen in den Codierungsstufen reduziert. Weitere Vorteile ergeben sich insbesondere dann, wenn bestimmte Primärelemente der Primärfolge besonders häufig vorkommen, und insbesondere ein großer Teil der Primärelemente der Primärfolge besonders selten vorkommt, so daß auch die Escapesequenzen besonders selten auftreten. Trifft dies beispielsweise für jeweils die Hälfte der Primärelemente des Primärvorrates der Primärfolge zu, so kann die Escapesequenz aus einem Escapeelement und einem der Elemente des Elementevorrates vorteilhaft gebildet werden, welches ebenso auch das Escapeelement sein kann. Ist die Anzahl der selten vorkommenden Primärelemente gleich dem Quadrat der Anzahl der häufig vorkommenden Primärelemente, so kann die Escapesequenz aus dem Escapeelement und zwei weiteren Elementen des Elementevorrates vorteilhaft gebildet werden. Ebenso kann entsprechend der Hochzahl bei beispielsweise einer höheren Potenz der Anzahl der selten vorkommenden Elemente gegenüber der Anzahl der häufig vorkommenden Elemente die Escapesequenz aus dem Escapeelement und einer Anzahl der Elemente des Elementevorrates gleich der Hochzahl vorteilhaft gebildet werden. Besteht beispielsweise die Primärfolge aus den Koeffizienten einer Diskret-Cosinus-Transformation von Bildwerten von Bildpunkten eines Abbildes, so ist beispielsweise für medizinische Bilder eine Escapesequenz bestehend aus dem Escapeelement und zwei Elementen des Elementevorrates vorteilhaft. In Abhängigkeit vom Detailreichtum des jeweiligen Bildes sind die Koeffizienten für bestimmte Werte eines Wertevorrates besonders häufig. Bei besonders detailarmen Bildern sind längere Escapesequenzen vorteilhaft. Eine günstige Länge der Escapesequenz wird häufig anhand von experimentellen Tests ermittelt.

Eine bevorzugte Ausführungsform der Erfindung ist dadurch gekennzeichnet, daß eine Markierung weiterer der Teilfolgen beendet wird bei einer Verwendung eines hierfür bestimmten Codewortes. Insbesondere bei längeren Elementfolgen und einem kleineren Codewortvorrat wird fallweise eine derart große Zahl von Teilfolgen vorgefunden, so daß die Anzahl der Codeworte des Codewortevorrates nicht mehr ausreicht, um weitere Teilfolgen zu markieren. Ebenso kann auch der Fall eintreten, daß insbesondere bei einer kleineren Anzahl von vorgesehenen Codierungsstufen eine weitere der Codierungsstufen nicht mehr hinzufügbar ist. In diesen Fällen wird beispielsweise das vereinbarungsgemäß zuletzt zuordenbare Codewort dazu benutzt, dies zu kennzeichnen. Dieses Codewort kann vereinbarungsgemäß zur Erleichterung und Beschleunigung bei der Decodierung der Codefolge ebenso die Markierung weiterer Teilfolgen beenden. Für den Fall, daß ein derartiges Codewort nicht vereinbart ist oder nicht benutzt wird, werden zwar bei der Codierung weitere der Codeworte nicht benutzt, eben weil weitere der vorgefundenen Teilfolgen nicht mehr markiert werden. Bei der Decodierung werden zwar die auch weiterhin markierten Teilfolgen verfügbar gehalten, sie werden aber bei der Codierung nicht mehr verwendet. Häufig wird die Zuordnung von Codeworten fortgesetzt, auch wenn das Hinzufügen von Codierungsstufen beendet ist, insbesondere bei einer Verwendung einer kleineren Anzahl von vorgesehenen Codierungsstufen. Dabei werden die fortgesetzt zugeordneten Codeworte in die jeweils bereits geketteten Codierungsstufen eingetragen, soweit dies möglich ist. Codeworte, welche zwar zugeordnet und damit vergeben sind, jedoch in einer Codierungsstufe mangels verfügbarer Codierungsstufen nicht mehr eingetragen werden konnten, werden auch nicht in die Codewortfolge eingetragen und sind für die Datenkompression nachfolgend auch nicht benutzbar.

Eine weitere bevorzugte Ausführungsform der Erfindung betrifft eine Codegenerierungseinrichtung zur Durchführung des Verfahrens nach einer der genannten Ausführungsformen der Erfindung und ist gekennzeichnet durch ein Speichermittel zu einer Speicherung der Codierungsstufen. Das Speichermittel kann dabei ein elektronischer Registerspeicher sein. Beispielsweise kann die Codierungsstruktur bitweise aufbereitet sein, mit jeweils einem eigenen Bit für die Markierung jeweils eines der markierten Codeworte oder jeweils eines eigenen Bits für die Markierung jeweils eines der Codierungsstufenzeiger. Ein derartiges Bit kann beispielsweise das höchstwertigste oder niedrigstwertigste Bit eines Registers sein. Mittels einer beispielsweise elektronischen Schaltwerksanordnung werden in das Speichermittel die zu markierenden Codeworte und Codierungsstufenzeiger eingespeichert und abgefragt. Dadurch kann eine derartige Schaltwerksanordnung mit insbesondere sehr kleinen Abmessungen aufgebaut werden. Insbesondere bei einem kleineren Elementevorrat sowie einem kleineren Codewortvorrat kann die Schaltwerksanordnung auf einer einzigen Halbleiterscheibe angeordnet werden. Daraus ergeben sich die bekannten Vorteile der Hochintegrationstechnologie. Insbesondere bei einer Anwendung für die Übertragung medizinischer Bilder ist eine große Leistungsfähigkeit der Schaltwerksanordnung erforderlich. Häufig werden zwischen 10 und 25 Bilder pro Sekunde bestehend aus rund 2000 mal 2000 Bildpunkten aufgezeichnet und mittels des erfindungsgemäßen Verfahrens komprimiert und übertragen. In einigen Anwendungsfällen sind dies auch beispielsweise 50 Bilder pro Sekunde mit jeweils 4000 mal 4000 Bildpunkten.

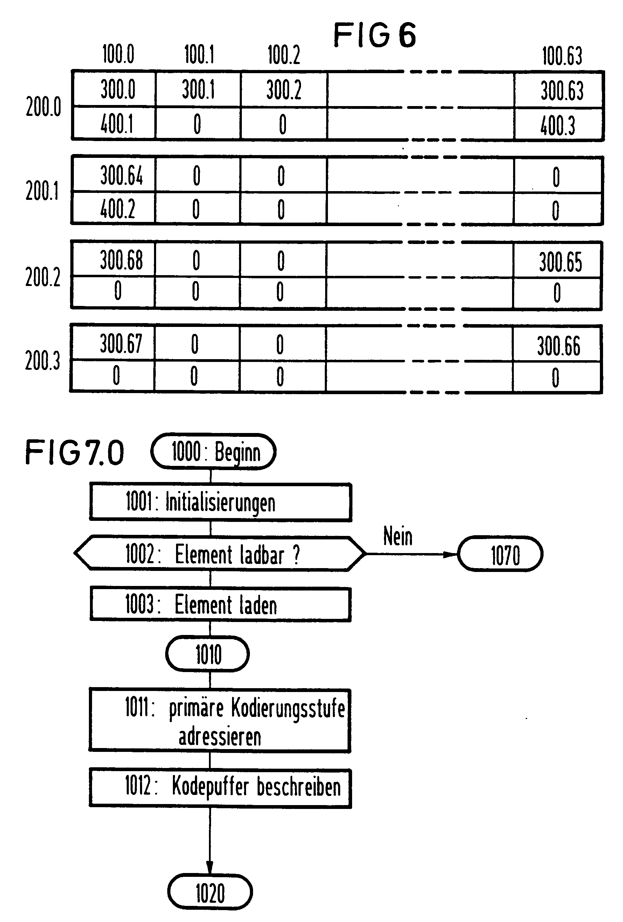

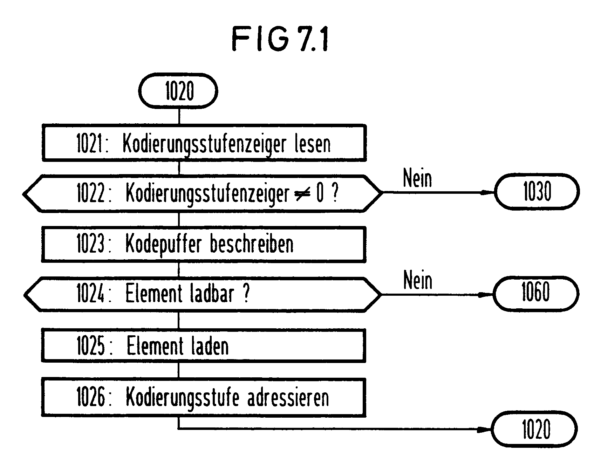

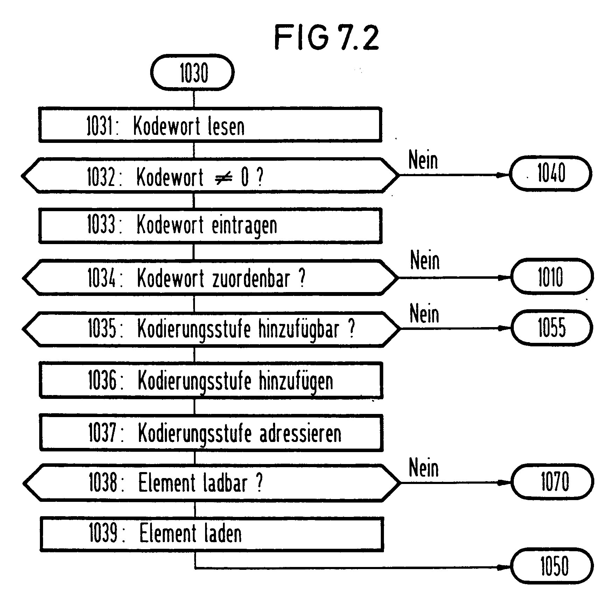

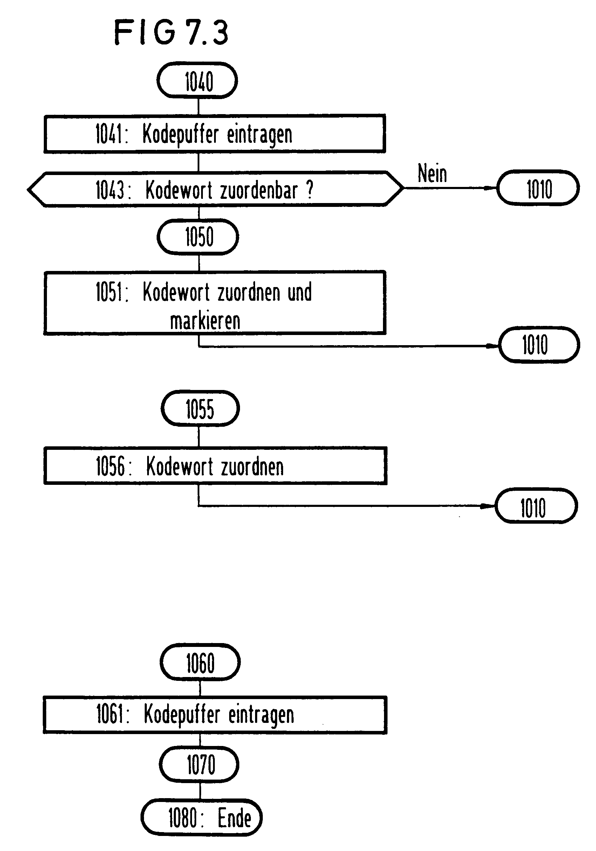

Hierbei ist die Durchführung des erfindungsgemäßen Verfahrens besonders vorteilhaft anwendbar beispielsweise mittels einer besonderen und speziell auf das erfindungsgemäße Verfahren abgestimmten Schaltungsanordnung. Der Aufbau einer derartigen besonders leistungsfähigen Schaltung ist insbesondere anhand des Flußdiagrammes gemäß Figur 7 vorteilhaft durchführbar, welches anhand eines Ausführungsbeispiels nachfolgend besonders erläutert ist.

Eine weitere bevorzugte Ausführungsform der Erfindung ist gekennzeichnet durch wenigstens einen direkt adressierbaren Datenspeicher des Speichermittels. Durch die Speicherung der Codierungsstruktur in einem direkt adressierbaren Datenspeicher sind insbesondere kostengünstige bevorzugte Ausführungsformen der Erfindung realisierbar. Beispielsweise die Verwendung eines oder mehrerer Plattenspeicher zur Speicherung der Codierungsstruktur durch eine Verwendung eines Codierungsstufenzeigers gebildet aus der jeweiligen Geräteadresse und jeweiligen Plattenadresse ist insbesondere vorteilhaft bei einem großen Elementevorrat und einem großen Codewortvorrat.

Eine weitere bevorzugte Ausführungsform der Erfindung ist dadurch gekennzeichnet, daß das Codewort, der Codierungsstufenzeiger, sowie Elemente der Elementfolge in einer binären Darstellung vorgesehen sind. Durch diese Umsetzung in die binäre Darstellung wird insbesondere bei der Speicherung ein möglichst geringer Speicherplatzbedarf realisierbar.

Eine bevorzugte Ausführungsform der Erfindung ist dadurch gekennzeichnet, daß genau ein Escapeelement verwendet wird mit einem bestimmten Zahlenwert. Insbesondere für Elementfolgen deren Elemente eine Häufung für niedrigstwertige Elementwerte aufweisen, ist ein Escapeelement eines höchstwertigen Zahlenwertes bevorzugt anwendbar. Besonders günstig ist beispielsweise für Elementfolgen, in welchen ein bestimmter Elementwert überhaupt nicht enthalten ist, die Verwendung dieses Elementwertes für das Escapeelement. Dies gilt beispielsweise für den Elementwert gleich Null für viele Anwendungsfälle.

Eine weitere bevorzugte Ausführungsform der Erfindung ist dadurch gekennzeichnet, daß ein Element der Elementfolge eine Datenbitanzahl aufweist wenigstens halb so groß wie eine Primärdatenbitanzahl eines Primärelementes einer Primärfolge, welches dadurch in eine niedrigstwertige Bitgruppe des Primärelementes gemäß der Datenbitanzahl und in die höchstwertige Bitgruppe aufteilbar ist. Dadurch ist in vorteilhafter Weise eine Escapesequenz festlegbar bestehend aus dem Escapelement und zwei Elementen des Elementvorrates.

Eine weitere bevorzugte Ausführungsform der Erfindung ist dadurch gekennzeichnet, daß eine Escapesequenz vorgesehen ist, welche aus dem Escapeelement besteht, dessen Zahlenwert größer oder gleich dem Zahlenwert des Escapeelemtnes ist, gefolgt von den beiden Elementen, welche jeweils aus den beiden Bitgruppen des Primärelementes zu einer Umsetzung eines der Primärelemente. Dadurch ist besonders einfach ein Primärelement in zwei Elemente der Escapesequenz umsetzbar.

Eine weitere bevorzugte Ausführungsform der Erfindung ist dadurch gekennzeichnet, daß die Primärfolge aus Koeffizienten einer Diskret-Cosinus-Transformation von Bildwerten von Bildpunkten eines Abbildes erzeugt wird in einem Transformationsverfahren zu einer Erzielung eines Häufungspunktes der Primärfolge bei einem bestimmten Zahlenwert. Insbesondere für wenig detailreiche Bilder weisen die Koeffizienten der Diskret-Cosinus-Transformation eine Häufung des Zahlenwertes nahe dem Zahlenwert Null auf. Dies gilt beispielsweise für besonders detailreiche Bilder einer medizinischen Diagnose etwa für Röntgenbilder. Derartige Bilder eignen sich durch die Häufung besonders für das Codegenerierungsverfahren. In einem Transformationsverfahren werden beispielsweise die positiven Zahlenwerte zu geradzahligen Primärelementen und die negativen Zahlenwerte zu ungeradzahligen Primärelementen transformiert. Daraus ergeben sich insbesondere Vorteile bei der Bildung der Escapesequenzen unter Verwendung der niedrigstwertigen und der höchstwertigen Bitgruppen der Primärelemente

Weitere bevorzugt günstige Ausführungsformen der Erfindung sind durch zahlreiche Tests, insbesondere mit medizinischen Bildern nachweisbar. Besonders günstig ist eine Codewortbitanzahl des Codewortes zwischen 10 und 16, eine Datenbitanzahl des Elementes zwischen vier und acht, sowie eine Primärbitanzahl der Primärelemente zwischen 10 und 16. Die bestmöglichen Ergebnisse sind häufig erzielbar mit einer Codewortbitanzahl gleich 14, einer Datenbitanzahl gleich 6, sowie einer Primärbitanzahl gleich 12.

Eine weitere bevorzugte Ausführungsform der Erfindung ist dadurch gekennzeichnet, daß jeweils das Codewort und der Codierungsstufenzeiger in einer gleichen der Elementpositionen einer der Codierungsstufen in einer gleichen Speicherzelle des Datenspeichers speicherbar vorgesehen sind. Dadurch sind das Codewort und der Codierungsstufenzeiger mittels eines Speicherzugriffs auf die Speicherzelle gleichzeitig auslesbar.

Eine weitere bevorzugte Ausführungsform der Erfindung ist dadurch gekennzeichnet, daß durch einen Speicherzugriff auf die Speicherzelle einerseits das Codewort in ein Register und andererseits der Codierungsstufenzeiger in ein weiteres der Register ladbar ist. Dadurch sind das Codewort und der Codierungsstufenzeiger gleichzeitig mit einem Speicherzugriff in verschiedene Register ladbar. Eine besonders rasche Durchführung der Codegenerierung ist auf diesem Wege erzielbar.

Eine weitere bevorzugte Ausführungsform der Erfindung ist dadurch gekennzeichnet, daß eine Codierungstufenanzahl der Codierungsstufen vorgesehen ist kleiner/gleich der Codewortanzahl der Codeworte. Eine Codierungsstufenanzahl gleich der Codewortanzahl erbringt den Vorteil, daß in jedem Fall alle Codeworte benutzt werden können, auch bei einer Elementfolge, welche ausschließlich aus durch Verlängerung erweiterten Teilfolgen besteht. Je mehr Verzweigungen bei den Teilfolgen vorgefunden werden, desto kleiner kann die Codierungsstufenanzahl sein.

Eine weitere bevorzugte Ausführungsform der Erfindung ist dadurch gekennzeichnet, daß die Codierungsstufenanzahl der Codierungsstufen zwischen einer Hälfte und einem Siebentel und insbesondere gleich einem Drittel der Codewortanzahl ist. Dadurch ist der Speicherplatzbedarf reduzierbar. Insbesondere bei einer Vielzahl von Tests ist beispielsweise für medizinische Bilder nachgewiesen, daß diese Werte für die Codierungsstufenanzahl günstig sind.

Eine weitere bevorzugte Ausführungsform der Erfindung ist dadurch gekennzeichnet, daß für die Teilfolgen eine Maximalanzahl der Elemente zwischen 100 und 500 vorgesehen ist. Dadurch ist beispielsweise bei leeren Bildblöcken eine größere Verzögerung der Codes vermeidbar. Diesbezüglich sind Werte der Maximalanzahl zwischen 100 und 500 bei zahlreichen Tests als günstig nachgewiesen. Der optimale Wert für die Maximalanzahl liegt bei 250.

Eine weitere bevorzugte Ausführungsform der Erfindung ist dadurch gekennzeichnet, daß das Codegenerierungsverfahren mittels eines Universalrechners durchgeführt wird. Dadurch kann beispielsweise durch den Einsatz höherer Programmiersprachen die korrekte Durchführung in bekannter Weise kontrolliert und überprüft werden. In bekannter Weise ist die Erstellung eines derartigen Programmes erleichtert durchführbar.

Die Erfindung wird anhand der Figuren näher erläutert, in welchem ein Ausführungsbeispiel dargestellt ist.

Die Figur 1 zeigt eine primäre Codierungsstufe vor der Bearbeitung des ersten Elementes der Elementfolge.

Die Figur 2 zeigt zwei Codierungsstufen nach der Bearbeitung des ersten Elementes der Elementfolge.

Die Figur 3 zeigt drei Codierungsstufen während der Bearbeitung der Codierung.

Die Figur 4 zeigt vier Codierungsstufen während der Bearbeitung der Codierung.

Die Figur 5 zeigt vier Codierungsstufen während der Bearbeitung der Codierung.

Die Figur 6 zeigt vier Codierungsstufen während der Bearbeitung der Codierung.

Die Figur 7 zeigt ein Flußdiagramm für die Durchführung der Codierung.

Die Figur 8 zeigt eine Anordnung für das Ausführungsbeispiel.

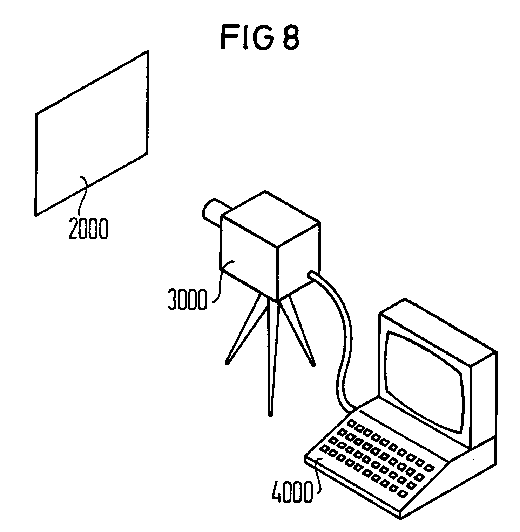

Wie die Figur 8 zeigt, wird als ein medizinisches Diagnosebild ein Röntgenbild 2000 von einer Kamera 3000 aufgezeichnet. Die dabei erhaltenen Bildwerte werden in einer Rechenanlage 4000 mittels einer Diskret-Cosinus-Transformation komprimiert gespeichert. Die dabei erhaltenen Koeffizienten werden mit dem erfindungsgemäßen Verfahren weiter komprimiert, gespeichert und archiviert auf Datenträgern. Dabei bilden die Koeffizienten von der Diskret-Cosinus-Transformation eine Primärfolge für das erfindungsgemäße Verfahren. Die Primärfolge wird mit Hilfe von Escapesequenzen umgesetzt in eine Elementfolge. Danach wird die Elementfolge mit Hilfe einer Codierungsstruktur codiert zu einer Codewortfolge, welche archiviert wird bei diesem Ausführungsbeispiel.

Wie die nachfolgende Tabelle 1 zeigt, wird beim Ausführungsbeispiel von einer Primärfolge 600 bestehend aus Primärelementen 600.0, 600.1, ... 600.5 ausgegangen.

Tabelle 1

```
600.0: 000000000000
600.1: 000000000000
600.2: 000000000000
600.3: 000000111111
600.4: 000000000000
600.5: 000000000000
```

Dabei besteht jedes der Primärelemente 600.0, 600.1, ...600.5 in einer binären Darstellung aus einer Primärbitanzahl von 12 Bits. In einem Umsetzungsverfahren wird bei diesem Ausführungsbeispiel die Primärfolge 600 in eine Elementfolge 700 umgesetzt bestehend aus den Elementen 700.0, 700.1, ... 700.7, welche jeweils eine Datenbitanzahl von 6 Bits in der binären Darstellung aufweisen. Vereinbarungsgemäß wird das Element mit dem höchstwertigen Zahlenwert als Escapeelement verwendet. Die Primärelemente der Primärfolge 600, deren Zahlenwert kleiner ist wie der Zahlenwert des Escapeelementes werden beim Umsetzungsverfahren jeweils umgesetzt zu Elementen desselben Zahlenwertes. Dies erfolgt für alle Primärelemente der Primärfolge 600 mit der einzigen Ausnahme betreffend das Primärelement 600.3, für welches eine Escapesequenz erforderlich ist. Das Primärelement 600.3 der Primärfolge 600 wird dabei in seine höchstwertige Bitgruppe und in seine niedrigstwertige Bitgruppe geteilt. Im Ausführungsbeispiel wird das Primärelement 600.3 umgesetzt zu einer Escapesequenz bestehend aus den Elementen 700.3, 700.4 und 700.5. Dabei ist das Element 700.3 das Escapeelement, welches am Beginn der Escapesequenz steht. Nach dem Escapeelement 700.3 folgt das Element 700.4, dessen Zahlenwert gleich ist dem Zahlenwert der niedrigstwertigen Bitgruppe des Primärelementes 600.3. Anschließend folgt das Element 700.5, dessen Zahlenwert gleich ist dem Zahlenwert der höchstwertigen Bitgruppe des Primärelementes 600.3 dieses Ausführungsbeispieles. Nach der Umsetzung der Escapesequenz wird das Primärelement 600.4 in das Element 700.6 umgesetzt, und das Primärelement 600.5 in das Element 700.7. Nach der Umsetzung wird die in der nachfolgenden Tabelle gezeigte Elementfolge 700 erhalten.

Tabelle 2

```
700.0: 000000
700.1: 000000
700.2: 000000
700:3: 111111
700.4: 111111
700.5: 000000
700.6: 000000
700.7: 000000
```

Die Kodierung der Elementfolge 700 erfolgt mit Hilfe einer Kodierungsstruktur bestehend aus Kodierungsstufen, in welcher für jeden der möglichen Zahlenwerte der Elemente jeweils eine Kodierungsstelle vorgesehen ist. Die einem Element zugeordnete Kodierungsstelle wird dabei mit Hilfe des Zahlenwertes aufgefunden.

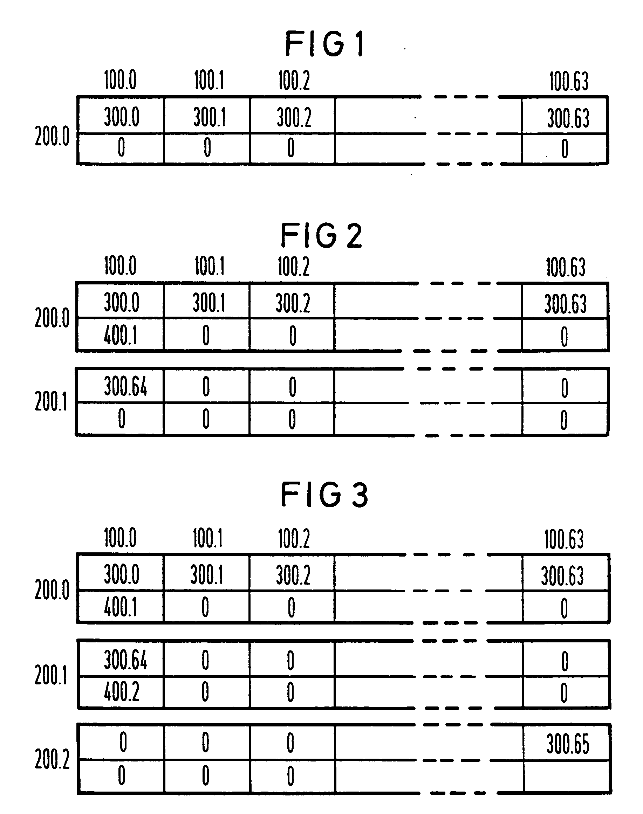

Wie die Figur 1 zeigt, soll eine primäre Kodierungsstufe 200.0 aus Kodierungsstelle 100.0, 100.1, ... 100.63 bestehen. In jeder der Kodierungsstufen ist dabei an jeder der Kodierungsstellen einerseits jeweils eines der Kodeworte markierbar und andererseits ist jeweils einer der Kodierungsstufen zeiger markierbar. In den Figuren ist dies in der Weise dargestellt, daß jede der Kodierungsstelle aus jeweils zwei Halbfeldern besteht. Das obere der beiden Halbfelder von einer der Kodierungsstellen ist dabei vorgesehen für eine Darstellung eines markierten Kodewortes. Das untere der beiden Halbfelder von einer der Kodierungsstellen ist vorgesehen für die Darstellung eines markierten Kodierungsstufenzeigers.

In jeder der Kodierungsstellen 100 ist jeweils nach der Initialisierung und unmittelbar vor Beginn der Kodierung einer Elementfolge einerseits jeweils das Kodewort 300.0, 300.1, ... 300.63 markiert und andererseits ist in keiner der Kodierungsstellen 100.0, 100.1, ... 100.63 der primären Kodierungsstufe 200.0 ein Kodierungsstufenzeiger markiert. In jeder der Kodierungsstellen 100 von Kodierungsstufen 200 bedeutet dabei ein Kodewortwert gleich 0, daß ein Kodewort nicht markiert ist. Ebenso bedeutet ein Kodierungsstufenzeigerwert gleich 0, daß ein Kodierungsstufenzeiger nicht markiert ist. Die einzige Ausnahme dabei bildet bei diesem Ausführungsbeispiel die Kodierungsstelle 100.0 in der primären Kodierungsstufe 200.0, an welcher ein Kodewortwert gleich 0 markiert ist. Diese Markierung ist deshalb zulässig, weil dieses Kodewort bereits während des Initialisierungsvorganges jedenfalls vor Beginn des Kodiervorganges markiert wird und im Zuge des weiteren Kodiervorganges nicht mehr verändert wird, und weil insbesondere an keiner anderen Kodierungsstelle der primären Kodierungsstufe ebenso wie in keiner anderen der Kodierungsstufen 200 dieser Kodewortwert markierbar ist.

Wie die folgende Tabelle 3 zeigt, sind in der primären Kodierungsstufe 200.0 an den Kodierungsstellen 100.0, 100.1, ... 100.63 jeweils Kodeworte 300.0, 300.1, ... 300.63 markiert bestehend aus jeweils einer Kodebitanzahl von 14 Bits.

Tabelle 3

```
300.0:  00000000000000
300.1:  00000000000001
300.2:  00000000000010
300.3:  00000000000011
. . . . . . . . . . . . . . . . . . . .
300.63: 00000000111111
```

In der Folge wird der Kodiervorgang begonnen und das erste in Tabelle 2 dargestellte Element 700.0 der Elementfolge 700 verarbeitet. Wie die Figur 2 zeigt, wird dabei gemäß dem Zahlenwert des Elementes 700.0 an der Kodierungsstelle 100.0 in der primären Kodierungsstufe 200.0 geprüft, ob ein Kodierungsstufenzeiger markiert ist. Dies ist vorerst nicht der Fall. Deshalb wird das markierte Kodewort 300.0 in die Kodewortfolge eingetragen. Anschließend wird eine der Kodierungsstufen in diesem Fall die Kodierungsstufe 200.1 hinzugefügt und durch den Kodierungsstufenzeiger 400.1 markiert an der Kodierungsstelle 100.0 der primären Kodierungsstufe 200.0.

Bei diesem Ausführungsbeispiel ist der Zahlenwert des Kodierungsstufenzeigers 400 jeweils gleich dem Index der Kodierungsstufe 200. Der markierte Zahlenwert des Kodierungsstufenzeigers 400.1, welcher die Kodierungsstufe 200.1 markiert, ist demnach gleich 1. Dabei bedeutet ein markierter Zahlenwert gleich 0, daß keine Markierungsstufe markiert ist. Dies ist insbesondere deshalb zulässig, weil die Kodierungsstufe 200.0 die primäre Kodierungsstufe ist, für die in keiner der Kodierungsstufen eine Markierung vorgesehen ist, so daß ein Zahlenwert gleich 0 hierfür verwendbar ist.

Das nächstfolgende Element 700.1 wird bearbeitet. An der diesem Element gemäß den Zahlenwert dieses Elementes zugeordneten Kodierungsstelle 100.0 wird in der Kodierungsstufe 200.1 ein weiteres Kodewort 300.64 markiert. Durch dieses Kodewort 300.64 ist dabei die Teilfolge bestehend aus dem Element 700.0 gefolgt vom Element 700.1 markiert.

Mit dem Element 700.1 wird weiter nach markierten Teilfolgen gesucht. Wie die Figur 3 zeigt, wird an der dem Element 700.1 gemäß dem Zahlenwert dieses Elementes zugeordneten Kodierungsstelle 100.0 in der primären Kodierungsstufe 200.0 der Kodierungsstufenzeiger 400.1 erkannt, durch welchen die Kodierungsstufe 200.1 markiert ist. In dieser Kodierungsstufe 200.1 wird an der dem nächstfolgenden Element 700.2 gemäß dem Zahlenwert dieses Elementes zugeordneten Kodierungsstelle 100.0 überprüft, ob ein Kodierungsstufenzeiger markiert ist. Dies ist vorerst nicht der Fall. Deshalb wird geprüft, ob an dieser Kodierungsstelle eines der Kodeworte markiert ist. Dies ist der Fall. Deshalb wird das markierte Kodewort 300.64 in die Kodewortfolge eingetragen. Danach wird eine weitere der Kodierungsstufen, in diesem Fall die Kodierungsstufe 200.2 hinzugefügt und durch den Kodierungsstufenzeiger 400.2 an der Kodierungsstelle markiert. Das nächstfolgende Element 700.3 wird bearbeitet. An der zu diesem Element gemäß dem Zahlenwert dieses Elementes zugeordneten Kodierungsstelle 100.63 wird in der hinzugefügten Kodierungsstufe 200.2 ein weiteres der Kodeworte 300.65 markiert. Durch dieses Kodewort ist die Teilfolge markiert bestehend aus den Elementen 700.1, 700.2 und 700.3.

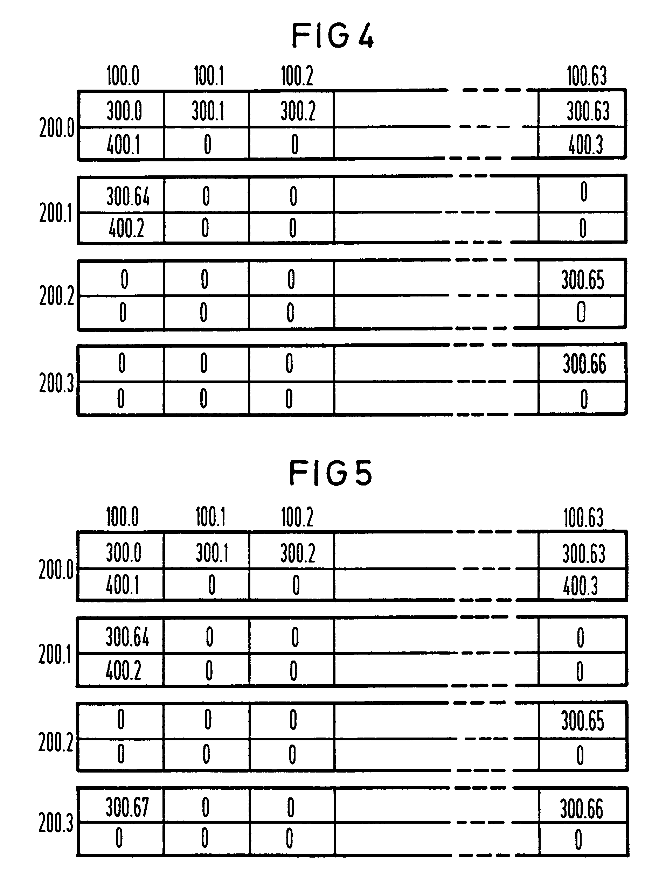

Mit dem Element 700.3 wird weiter nach Teilfolgen gesucht. Wie die Figur 4 zeigt, wird an der dem Element 700.3 gemäß dem Zahlenwert dieses Elementes zugeordneten Kodierungsstelle 100.63 in der primären Kodierungsstufe 200.0 geprüft, ob ein Kodierungsstufenzeiger markiert ist. Dies ist vorerst nicht der Fall. Deshalb wird das an dieser KS 100.63 in der primären Kodierungsstufe 200.0 markierte Kodewort 300.63 in die Kodewortfolge eingetragen. Nachfolgend wird bei diesem Ausführungsbeispiel die Kodierungsstufe 200.3 hinzugefügt und durch den Kodierungsstufenzeiger 400.3 an der KS 100.63 in der primären Kodierungsstufe 200.0 markiert. Das nächste Element 700.4 wird verarbeitet. An der diesem Element 700.4 gemäß dem Zahlenwert dieses Elementes zugeordneten Kodierungs stelle 100.63 wird in der hinzugefügten Kodierungsstufe 200.3 ein weiteres Kodewort 300.66 markiert. Durch dieses Kodewort ist eine Teilfolge markiert bestehend aus den Elementen 700.3 und 700.4.

Mit dem Element 700.4 wird weiter nach Teilfolgen gesucht. Wie die Figur 5 zeigt, ist in der primären Kodierungsstufe 200.0 an der dem Element 700.4 gemäß dem Zahlenwert dieses Elementes zugeordneten Kodierungsstelle 100.63 durch den Kodierungsstufenzeiger 400.3 die Kodierungsstufe 200.3 markiert. Das nächstfolgende Element 700.5 wird verarbeitet. An der dem Element 700.5 gemäß dem Zahlenwert dieses Elementes zugeordneten Kodierungsstelle 100.0 wird in der Kodierungsstufe 200.3 geprüft, ob ein Kodierungsstufenzeiger markiert ist. Dies ist nicht der Fall. Deshalb wird geprüft, ob an dieser Kodierungsstelle 100.0 in der Kodierungsstufe 200.3 eines der Kodeworte markiert ist. Dies ist vorerst nicht der Fall. Deshalb wird das Kodewort 300.63 in die Kodewortfolge eingetragen. An der Kodierungsstelle 100.0 der Kodierungsstufe 200.3 wird ein weiteres der Kodeworte 300.67 markiert. Durch dieses Kodewort ist eine Teilfolge bestehend aus den Elementen 700.4 und 700.5 markiert.

Mit dem Element 700.5 wird weiter nach Teilfolgen gesucht. Wie die Figur 6 zeigt, wird an der dem Element 700.5 gemäß dem Zahlenwert dieses Elementes zugeordneten Kodierungsstelle 100.0 in der primären Kodierungsstufe 200.0 der Kodierungsstufenzeiger 400.1 vorgefunden, durch welchen die Kodierungsstufe 200.1 markiert ist. Das nächstfolgende Element 700.6 wird verarbeitet. In der Kodierungsstufe 200.1 wird an der dem Element 700.6 gemäß dem Zahlenwert dieses Elementes zugeordneten Kodierungsstelle 100.0 der Kodierungsstufenzeiger 400.2 vorgefunden, durch welchen die Kodierungsstufe 200.2 markiert ist. Das nächstfolgende Element 700.7 wird verarbeitet. In der Kodierungsstufe 200.2 wird an der dem Element 700.7 gemäß dem Zahlenwert dieses Elementes zugeordneten Kodierungsstelle 100.0 geprüft, ob ein Kodierungsstufenzeiger markiert ist. Das ist nicht der Fall. Deshalb wird geprüft, ob in der Kodierungsstufe 200.2 an der KS 100.0 eines der Kodeworte markiert ist. Dies ist vorerst nicht der Fall. Deshalb wird das Kodewort 300.64 in die Kodewortfolge eingetragen. Anschließend wird in der Kodierungsstufe 200.2 an der Kodierungsstelle 100.0 ein weiteres der Kodeworte 300.68 markiert. Durch dieses Kodewort ist eine Teilfolge markiert bestehend aus den Elementen 700.5, 700.6 und 700.7.

Mit dem Element 700.7 wird weiter nach Teilfolgen gesucht. In der primären Kodierungsstufe 200.0 wird an der dem Element 700.7 gemäß dem Zahlenwert dieses Elementes zugeordneten Kodierungsstelle 100.0 der Kodierungsstufenzeiger 400.1 vorgefunden. Nachfolgend wird versucht, das nächstfolgende Element zu verarbeiten. Da bei diesem Ausführungsbeispiel kein weiteres Element vorhanden ist, wird das markierte Kodewort 300.0 in die Kodewortfolge eingetragen.

Bei diesem Ausführungsbeispiel wurde demnach, wie die nachfolgende Tabelle 4 zeigt, die Kodefolge 800 erzeugt.

## Tabelle 4

```
800.0 (= 300.0)    : 00000000000000
800.1 ( = 300.64) : 00000001000000
800.2 ( = 300.63) : 00000000111111
800.3 ( = 300.63) : 00000000111111
800.4 ( = 300.64) : 00000001000000
800.5 ( = 300.0)  : 00000000000000
```

Die Kodewortfolge 800 ist dabei das Ergebnis des Kodiervorganges dieses Ausführungsbeispieles.

Für eine Durchführung des Kodiervorganges ist das in Figur 7 dargestellte Flußdiagramm insbesondere beim Herstellen einer elektronischen Einrichtung hilfreich. Dieses Flußdiagramm ist ebenso bei der Erstellung eines in einer der Programmiersprachen formulierten Programmablaufs dienlich.

Der Beginn des Kodiervorganges dieses Ausführungsbeispieles ist in dem in Figur 7.0 dargestellten Flußdiagramm an der Instruktion 1000 dargestellt.

Es folgt die Instruktion 1001 mit einer Durchführung von Initialisierungen, insbesondere mit der Markierung der primären Teilfolgen in der primären Kodierunssstufe.

Weiters folgt die Instruktion 1002 mit der Abfrage, ob ein Element der Elementfolge ladbar ist. Falls dies beispielsweise zufolge Dateiende nicht möglich ist, wird verzweigt zur Instruktion 1070, welche in Figur 7.3 dargestellt ist.

Danach folgt die Instruktion 1003 mit dem Laden des ersten Elementes der Elementfolge, und das Aufbereiten der über den Zahlenwert des Elementes ermittelbaren und dem geladenen Element zugeordneten Kodierungsstelle innerhalb der Kodierungsstufen.

Es folgt die Instruktion 1010, auf welche von den in Figur 7.3 dargestellten Abfragen 1042 fallweise verzweigt wird, und auf welche ebenso von den in Figur 7.2 dargestellten Abfragen 1034 und 1035 fallweise verzweigt wird, und auf welche unbedingt verzweigt wird nach Ausführung der in Figur 7.3 dargestellten Instruktion 1051.

Danach folgt die Instruktion 1011 mit der Adressierung der primären Kodierungsstufe.

Danach folgt die Instruktion 1012 mit dem Eintrag in den Kodepuffer. Dabei wird ein Kodewort eingetragen, welches aus der primären Kodierungsstufe entnommen ist aus der Kodierungsstelle, welche ermittelbar ist über den Zahlenwert des jeweils zuletzt geladenen Elementes.

Es folgt die Instruktion 1020, welche in Figur 7.1 dargestellt ist, und auf welche unbedingt verzweigt wird nach Ausführung der Instruktion 1026, welche in Figur 7.1 dargestellt ist.

Danach folgt die Instruktion 1021 mit dem Lesen des Kodierungsstufenzeigers aus der zuletzt adressierten Kodierungsstufe von der Kodierungsstelle, welche ermittelbar ist über den Zahlenwert des jeweiligen zuletzt geladenen Elementes.

Danach folgt die Instruktion 1022 mit der Abfrage, ob der zuletzt gelesene Kodierungsstufenzeiger verschieden von Null ist. Falls dies nicht der Fall ist, wird verzweigt zur Instruktion 1030, welche in Figur 7.3 dargestellt ist.

Danach folgt die Instruktion 1023 mit dem Eintrag in den Kodepuffer. Dabei wird ein Kodewort eingetragen, welches aus der zuletzt adressierten Kodierungsstufe entnommen ist aus der Kodierungsstelle, welche ermittelbar ist über den Zahlenwert des jeweils zuletzt geladenen Elementes.

Danach folgt die Instruktion 1024 mit der Abfrage, ob ein Element der Elementfolge ladbar ist. Falls dies beispielsweise zufolge Dateiende nicht möglich ist, wird verzweigt zur Instruktion 1060, welche in Figur 7.4 dargestellt ist.

Danach folgt die Instruktion 1025 mit dem Laden des nächstfolgenden Elementes der Elementfolge, und dem Aufbereiten der über den Zahlenwert des Elementes ermittelbaren und dem geladenen Element zugeordneten Kodierungsstelle innerhalb der Kodierungsstufen.

Danach folgt die Instruktion 1026 mit der Adressierung der Kodierungsstufe, welche durch den zuletzt gelesenen Kodierungsstufenzeiger ermittelbar ist.

Danach folgt unbedingt die Verzweigung zur Instruktion 1020, welche in Figur 7.1 dargestellt ist.

Danch folgt die Instruktion 1030, welche in Figur 7.2 dargestellt ist, und auf welche fallweise von der Instruktion 1022 verzweigt wird, welche in Figur 7.1 dargestellt ist.

Danach folgt die Instruktion 1031 mit dem Lesen des Kodewortes aus der zuletzt adressierten Kodierungsstufe von der Kodierungsstelle, welche ermittelbar ist über den Zahlenwert des jeweils zuletzt geladenen Elementes.

Danach folgt die Instruktion 1032 mit der Abfrage, ob das zuletzt gelesene Kodewort verschieden von Null ist. Falls dies nicht der Fall ist, wird verzweigt zur Instruktion 1040, welche in Figur 7.3 dargestellt ist.

Danach folgt die Instruktion 1033 mit dem Eintragen des zuletzt gelesenen Kodewortes in die auszugebende Kodewortfolge.

Danach folgt die Instruktion 1034 mit der Abfrage, ob ein weiteres der Kodeworte verfügbar und zuordenbar ist. Falls dies nicht der Fall ist, weil beispielsweise bereits alle Kodeworte zu Teilfolgen der Elementfolge zugeordnet sind, also kein weiteres der Kodeworte verfügbar und zuordenbar ist, wird zur Instruktion 1010 verzweigt, welche in Figur 7.0 dargestellt ist.

Danach folgt die Instruktion 1035 mit der Abfrage, ob eine weitere der Kodierungsstufen verfügbar und hinzufügbar ist. Falls dies nicht der Fall ist, weil beispielsweise bereits alle Kodierungsstufen hinzugefügt und gekettet sind an Kodierungsstufen, also keine weitere der Kodierungsstufen verfügbar und hinzufügbar ist, wird zur Instruktion 1010 verzweigt, welche in Figur 7.0 dargestellt ist.

Danach folgt die Instruktion 1036 mit dem Hinzufügen und Ketten einer der verfügbaren und hinzufügbaren Kodierungsstufen. Dabei wird der Kodierungsstufenzeiger, über welchen diese Kodierungsstufe gekettet und ermittelbar ist, eingetragen und markiert in der zuletzt adressierten Kodierungsstufe an der Kodierungsstelle, welche ermittelbar ist über den Zahlenwert des jeweils zuletzt geladenen Elementes.

Danach folgt die Instruktion 1037 mit der Adressierung der hinzugefügten Kodierungsstufe.

Danach folgt die Instruktion 1038, mit der Abfrage, ob ein Element der Elementfolge ladbar ist. Falls dies beispielsweise zufolge Dateiende nicht möglich ist, wird verzweigt zur Instruktion 1060, welche in Figur 7.3 dargestellt ist.

Danach folgt die Instruktion 1039 mit dem Laden des nächstfolgenden Elementes der Elementfolge, und das Aufbereiten der über den Zahlenwert des Elementes ermittelbaren und dem geladenen Element zugeordneten Kodierungsstelle innerhalb der Kodierungsstufen.

Danach folgt unbedingt die Verzweigung zur Instruktion 1050, welche in Figur 7.3 dargestellt ist.

Danach folgt die in Figur 7.3 dargestellte Instruktion 1040, auf welche fallweise verzweigt wird von der Instruktion 1032, welche in Figur 7.2 dargestellt ist.

Danach folgt die Instruktion 1041 mit dem Lesen des zuletzt in den Kodepuffer eingetragenen Kodewortes, und das Eintragen dieses Kodewortes in die auszugebende Kodewortfolge.

Danach folgt die Instruktion 1042 mit der Abfrage, ob ein weiteres der Kodeworte verfügbar und zuordenbar ist. Falls dies nicht der Fall ist, weil beispielsweise bereits alle Kodeworte zu Teilfolgen der Elementfolge zugeordnet sind, also kein weiteres der Kodeworte verfügbar und zuordenbar ist, wird zur Instruktion 1010 verzweigt, welche in Figur 7.0 dargestellt ist.

Danach folgt die Instruktion 1050, auf welche unbedingt nach Ausführung der Instruktion 1039 verzweigt wird, welche in Figur 7.2 dargestellt ist.

Danach folgt die Instruktion 1051 mit dem Zuordnen und Markieren eines weiteren der Kodeworte. Dabei wird das zugeordnete Kodewort eingetragen und markiert in der zuletzt adressierten Kodierungsstufe an der Kodierungsstelle, welche ermittelbar ist über den Zahlenwert des zuletzt geladenen Elementes.

Danach folgt unbedingt die Verzweigung zur Instruktion 1010, welche in Figur 7.0 dargestellt ist.

Danach folgt die Instruktion 1055, auf welche fallweise verzweigt wird von der Instruktion 1035, welche in Figur 7.2 dargestellt ist.

Danach folgt die Instruktion 1056 mit dem Zuordnen eines weiteren der Codeworte. Dabei wird dieses zugeordnete Codewort nicht eingetragen und in der Folge auch nicht mehr verwendet. Die diesem Codewort zugeordnete Teilfolge wird nachfolgend jeweils bei der Codierung mit dem Codewort der kürzeren und nicht erweiterten Teilfolge in die Codewortfolge eingetragen.

Danach folgt unbedingt die Verzweigung zur Instruktion 1010, welche in Figur 7.0 dargestellt ist.

Danach folgt die in Figur 7.3 dargestellte Instruktion 1060, auf welche fallsweise von der in Figur 7.1 dargestellten Instruktion 1024 verzweigt wird.

Danach folgt die Instruktion 1061 mit dem Lesen des zuletzt in den Kodepuffer eingetragenen Kodewortes, und das Eintragen dieses Kodewortes in die auszugebende Kodewortfolge.

Danach folgt die Instruktion 1070, auf welche fallsweise von der in Figur 7.0 dargestellten Instruktion 1002 verzweigt wird und auf welche fallweise von der in Figur 7.2 dargestellten Instruktion 1038 verzweigt wird.

Danach folgt die Instruktion 1080 mit dem Ende des Kodierungsvorganges.

## Patentansprüche

1. Verfahren zur Codierung einer Folge von Elementen durch Erzeugng eines Lempel-Ziv-Codes für Teilfolgen, mit folgenden Schritten:
   - es wird eine baumförmige verkettete Liste aus Tabellen, Codierungsstufen genannt, aufgebaut;
   - in jeder dieser Codierungsstufen ist für jedes Element ein Platz, Codierungsstelle genannt, vorgesehen, an welchem diesem Element ein Codewort und ein Codierungsstufenzeiger auf eine nachfolgende Codierungsstufe zugeordnet sein können;
   - ein Codewort zu einer zu codierenden Teilfolge wird dieser Teilfolge durch eine Codierungsstelle zugeordnet, auf welche derjenige Codierungsstufenzeiger zeigt, welcher zu einer Unterteilfolge gehört, die durch Streichung des letzten Elements der zu codierenden Teilfolge entsteht.

2. Verfahren nach Anspruch 1, bei dem ein Codewort zwischen 10 und 16 Bit vorzugsweise 14 Bit umfaßt.

3. Verfahren nach einem der vorhergehenden Ansprüche, bei dem ein Element mit 4 bis 8 Bit vorzugsweise mit 6 Bit dargestellt wird.

4. Verfahren nach einem der vorhergehenden Ansprüche, bei dem die Zahl der Codierungsstufen zwischen einer Hälfte und 1/7tel der Zahl der Codeworte liegt und vorzugsweise 1/3tel der Codeworte beträgt.

11

**5.** Verfahren nach einem der vorhergehenden Ansprüche, bei dem die maximale Zahl der Elemente von Teilfolgen zwischen 100 und 500 liegt und vorzugsweise gleich 250 ist.

**6.** Verfahren nach einem der vorhergehenden Ansprüche, bei dem die Elemente Koeffizienten einer diskreten Cosinustransformation von Bildwerten eines digitalen Bildes sind.

**7.** Verfahren nach einem der vorhergehenden Ansprüche, wobei die Verfahrensschritte mittels eines Universalrechners ausgeführt werden.

**Claims**

**1.** Process for coding a sequence of elements by generating a Lempel/Ziv code for partial sequences, having the following steps:
- a tree-like linked list is constructed from tables, referred to as coding steps;
- provided in each of these coding steps for each element is a location, referred to as coding site, at which a code word and a coding step pointer to a subsequent coding step may be assigned to this element;
- a code word of a partial sequence to be coded is assigned to this partial sequence by a coding site, to which the coding step pointer belonging to a subsidiary partial sequence which is produced by deletion of the last element of the partial sequence to be coded points.

**2.** Process according to Claim 1, in which a code word comprises between 10 and 16, preferably 14, bits.

**3.** Process according to one of the preceding claims, in which an element is represented with 4 to 8, preferably with 6, bits.

**4.** Process according to one of the preceding claims, in which the number of coding steps is between one half and one seventh of the number of code words, and is preferably one third of the code words.

**5.** Process according to one of the preceding claims, in which the maximum number of elements of partial sequences is between 100 and 500, and is preferably equal to 250.

**6.** Process according to one of the preceding claims, in which the elements are coefficients of a discrete cosine transform of image values of a digital image.

**7.** Process according to one of the preceding claims, the process steps being executed by means of a general-purpose computer.

**Revendications**

**1.** Procédé de codage d'une suite d'éléments en produisant un code de Lempel-Ziv pour des suites partielles, comprenant les étapes suivantes :
- on forme une liste concaténée arborescente de tableaux, appelés étages de codage ;
- on prévoit dans chacun de ces étages de codage pour chaque élément, une place, appelée emplacement de codage, où un mot de code et un pointeur d'étages de codage indiquant un étage de codage suivant peuvent être associés à cet élément;
- on associe un mot de code appartenant à une suite partielle à coder à cette suite partielle par un emplacement de codage, que montre celui des pointeurs d'étages de codage appartenant à une sous-suite partielle, qui apparaît en effaçant le dernier élément de la suite partielle à coder.

**2.** Procédé suivant la revendication 1, dans lequel un mot de code comprend entre 10 et 16 bits, de préférence 14 bits.

**3.** Procédé suivant l'une des revendications précédentes, dans lequel on représente un élément par 4 à 8 bits, de préférence par 6 bits.

4. Procédé suivant l'une des revendications précédentes, dans lequel le nombre des étages de codage est compris entre une moitié et un septième du nombre des mots de code et est de préférence un tiers des mots de code.

5. Procédé suivant l'une des revendications précédentes, dans lequel le nombre maximal des éléments de suites partielles est compris entre 100 et 500 et est de préférence égal à 250.

6. Procédé suivant l'une des revendications précédentes, dans lequel les éléments sont des coefficients d'une transformation à cosinus discret de valeurs d'une image numérique.

7. Procédé suivant l'une des revendications précédentes, dans lequel on met en oeuvre les étapes opératoires au moyen d'un calculateur à usage général.

# FIG 1

| | 100.0 | 100.1 | 100.2 | | | 100.63 |
|---|---|---|---|---|---|---|
| 200.0 | 300.0 | 300.1 | 300.2 | | | 300.63 |
| | 0 | 0 | 0 | | | 0 |

# FIG 2

| | 100.0 | 100.1 | 100.2 | | | 100.63 |
|---|---|---|---|---|---|---|
| 200.0 | 300.0 | 300.1 | 300.2 | | | 300.63 |
| | 400.1 | 0 | 0 | | | 0 |
| 200.1 | 300.64 | 0 | 0 | | | 0 |
| | 0 | 0 | 0 | | | 0 |

# FIG 3

| | 100.0 | 100.1 | 100.2 | | | 100.63 |
|---|---|---|---|---|---|---|
| 200.0 | 300.0 | 300.1 | 300.2 | | | 300.63 |
| | 400.1 | 0 | 0 | | | 0 |
| 200.1 | 300.64 | 0 | 0 | | | 0 |
| | 400.2 | 0 | 0 | | | 0 |
| 200.2 | 0 | 0 | 0 | | | 300.65 |
| | 0 | 0 | 0 | | | 0 |

# FIG 4

| | 100.0 | 100.1 | 100.2 | | 100.63 |
|---|---|---|---|---|---|
| **200.0** | 300.0 | 300.1 | 300.2 | | 300.63 |
| | 400.1 | 0 | 0 | | 400.3 |
| **200.1** | 300.64 | 0 | 0 | | 0 |
| | 400.2 | 0 | 0 | | 0 |
| **200.2** | 0 | 0 | 0 | | 300.65 |
| | 0 | 0 | 0 | | 0 |
| **200.3** | 0 | 0 | 0 | | 300.66 |
| | 0 | 0 | 0 | | 0 |

# FIG 5

| | 100.0 | 100.1 | 100.2 | | 100.63 |
|---|---|---|---|---|---|
| **200.0** | 300.0 | 300.1 | 300.2 | | 300.63 |
| | 400.1 | 0 | 0 | | 400.3 |
| **200.1** | 300.64 | 0 | 0 | | 0 |
| | 400.2 | 0 | 0 | | 0 |
| **200.2** | 0 | 0 | 0 | | 300.65 |
| | 0 | 0 | 0 | | 0 |
| **200.3** | 300.67 | 0 | 0 | | 300.66 |
| | 0 | 0 | 0 | | 0 |

## FIG 6

| | 100.0 | 100.1 | 100.2 | | 100.63 |
|---|---|---|---|---|---|
| 200.0 | 300.0 | 300.1 | 300.2 | | 300.63 |
| | 400.1 | 0 | 0 | | 400.3 |

| | | | | | |
|---|---|---|---|---|---|
| 200.1 | 300.64 | 0 | 0 | | 0 |
| | 400.2 | 0 | 0 | | 0 |

| | | | | | |
|---|---|---|---|---|---|
| 200.2 | 300.68 | 0 | 0 | | 300.65 |
| | 0 | 0 | 0 | | 0 |

| | | | | | |
|---|---|---|---|---|---|
| 200.3 | 300.67 | 0 | 0 | | 300.66 |
| | 0 | 0 | 0 | | 0 |

## FIG 7.0

1000: Beginn

1001: Initialisierungen

1002: Element ladbar ? — Nein → 1070

1003: Element laden

1010

1011: primäre Kodierungsstufe adressieren

1012: Kodepuffer beschreiben

1020

# FIG 7.1

1020

1021: Kodierungsstufenzeiger lesen

1022: Kodierungsstufenzeiger $\neq$ 0 ?  →  Nein  →  1030

1023: Kodepuffer beschreiben

1024: Element ladbar ?  →  Nein  →  1060

1025: Element laden

1026: Kodierungsstufe adressieren

1020

# FIG 7.2

```
                    ( 1030 )
         ┌──────────────────────────┐
         │ 1031 : Kodewort lesen     │
         └──────────────────────────┘
                                              Nein
         ⟨ 1032 : Kodewort ≠ 0 ? ⟩──────────────────►( 1040 )
         ┌──────────────────────────┐
         │ 1033 : Kodewort eintragen │
         └──────────────────────────┘
                                              Nein
         ⟨ 1034 : Kodewort zuordenbar ? ⟩──────────►( 1010 )
                                              Nein
         ⟨ 1035 : Kodierungsstufe hinzufügbar ? ⟩──►( 1055 )
         ┌────────────────────────────────┐
         │ 1036 : Kodierungsstufe hinzufügen │
         └────────────────────────────────┘
         ┌──────────────────────────────────┐
         │ 1037 : Kodierungsstufe adressieren │
         └──────────────────────────────────┘
                                              Nein
         ⟨ 1038 : Element ladbar ? ⟩────────────────►( 1070 )
         ┌──────────────────────────┐
         │ 1039 : Element laden      │
         └──────────────────────────┘
                                                      ( 1050 )
```

# FIG 7.3

( 1040 )

| 1041: Kodepuffer eintragen |

< 1043: Kodewort zuordenbar ? >  —— Nein ——> ( 1010 )

( 1050 )

| 1051: Kodewort zuordnen und
markieren |  ——> ( 1010 )

( 1055 )

| 1056: Kodewort zuordnen |  ——> ( 1010 )

( 1060 )

| 1061: Kodepuffer eintragen |

( 1070 )

( 1080: Ende )

# FIG 8

2000

3000

4000